(19) Europäisches Patentamt
European Patent Office
Office européen des brevets

(11) Publication number: **0 114 061 A2**

(12) **EUROPEAN PATENT APPLICATION**

(21) Application number: **84100232.2**

(22) Date of filing: **11.01.84**

(51) Int. Cl.³: **H 01 L 27/08**

(30) Priority: **12.01.83 JP 2218/83**

(43) Date of publication of application: **25.07.84 Bulletin 84/30**

(84) Designated Contracting States: **DE FR GB NL**

(71) Applicant: **HITACHI, LTD., 6, Kanda Surugadai 4-chome Chiyoda-ku, Tokyo 100 (JP)**

(72) Inventor: **Komoriya, Goh, 6-34-20, Jinguumae Shibuya-ku, Tokyo (JP)**
Inventor: **Hanamura, Syoji, 1473-A1-5, Josuihoncho, Kodaira-shi Tokyo (JP)**
Inventor: **Aoki, Masaaki, 4-6-12, Minamiaoyama Minato-ku, Tokyo (JP)**
Inventor: **Minato, Osamu, 2196-660, Hirai Hinodemachi, Nishitama-gun Tokyo (JP)**
Inventor: **Masuhara, Toshiaki, 2196-278, Hirai Hinodemachi, Nishitama-gun Tokyo (JP)**

(74) Representative: **Patentanwälte Beetz sen. - Beetz jun. Timpe - Siegfried - Schmitt-Fumian, Steinsdorfstrasse 10, D-8000 München 22 (DE)**

(54) **Semiconductor device having CMOS structures.**

(57) A CMOS type semiconductor integrated circuit consisting of p-channel MOS transistors and n-channel MOS transistors, is operated at temperatures lower than 100°K, and electric power and input signals are applied thereto, and output signals are taken out therefrom.

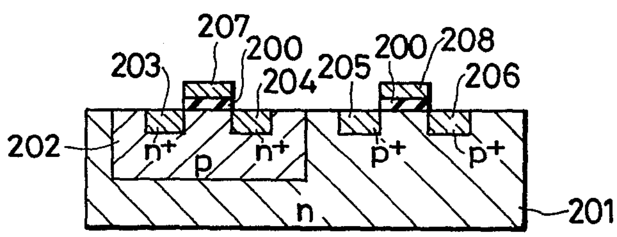


EP 0 114 061 A2

Title of the Invention

SEMICONDUCTOR DEVICE HAVING CMOS STRUCTURES

Background of the Invention

The present invention relates to a CMOS type integrated circuit, and particularly to a semiconductor device which operates at very high speeds and which can be highly integrated.

In a conventional CMOS integrated circuit consisting of n-channel MOS transistors (NMOS) and p-channel MOS transistors (PMOS), the carrier mobility remains constant, and the operation speed can be increased only by reducing the size of the device in the manufacturing process. However, there are limitations on reducing the size of the device since operation of the n-channel MOS transistors must be electrically isolated from operation of the p-channel MOS transistors, and the latch-up phenomenon must be restrained. With conventional CMOS integrated circuits, furthermore, it is difficult to reduce gate capacitance, junction capacitance and capacitance of interconnection lines, which are parasitic to the substrate or well regions.

Fig. 1 is a section view of the structure of a typical CMOS device, in which a p-channel MOS transistor Q1 consists of a gate 1, a gate oxide film 2, a source 3 and a drain 4 of $p^+$-diffusion layer, which are formed in an n-well region 5. An n-channel MOS transistor Q2 consists of a gate 1, a gate oxide film 2, a source 6 and a drain 7 of n-diffusion layer, which are formed in a p-well region 8. A junction field-effect transistor Q3 has a p-well 8 with an open hole that serves as a gate, with a drain 9 and a source 11 of $n^+$-diffusion layer formed on the hole. If the two n-channel MOS transistors or the two p-channel MOS transistors are formed close to each other, a parasitic n-channel MOS transistor or a parasitic p-channel MOS transistor is formed. When the MOS transistors are formed close to one another, the parasitic MOS transistor hinders the electric isolation between them. When the p-channel MOS transistor and the n-channel MOS transistor are formed close to each other, the latch-up phenomenon develops due to a parasitic bipolar transistor that is formed in the well region and in the substrate. Because of these reasons, it is difficult to reduce the size of the elements. To increase the operation speed of CMOS devices, however,

there is no way other than by increasing the current gain ß by reducing the size of the device in the manufacturing process.

Summary of the Invention

The object of the present invention is to provide a CMOS-type semiconductor integrated circuit which operates at very high speeds, which can be highly integrated and which consumes little electric power.

According to one embodiment of the present invention, use is made, at a temperature lower than 100°K, of a semiconductor integrated circuit of a so-called CMOS structure, in which a field-effect transistor with source and drain regions of a first type of electric conductivity, and a field-effect transistor with source and drain regions of a second type of electric conductivity are formed in the regions having different conductivity types in a silicon substrate.

According to another embodiment of the present invention, use is made, at a temperature lower than 20°K, of a semiconductor integrated circuit in which a first field-effect transistor with source and drain regions of a first type of conductivity, and a second field-effect transistor with source and drain regions of a second type of conductivity, are formed in the regions having the same conductivity type in a silicon substrate.

According to a further embodiment of the present invention, a well region of a second type of conductivity having an opening, is provided on the surface of a silicon substrate of a first type of conductivity having a first highly doped region in the bottom portion thereof, a second highly doped region of the first type of conductivity in the opening, a lightly doped region sandwiched between the first and second highly doped regions exhibits a high resistance over a temperature range in which the impurities freeze out, and an electric current is supplied to an element in the well region via the high resistance.

Namely, according to the present invention, a CMOS type semiconductor integrated circuit consisting of an n-channel MOS transistor and a p-channel MOS transistor is cooled to a very low temperature, and electric power, and input signals are applied thereto, and output signals are taken out therefrom. In other words, the present invention operates the CMOS type semiconductor integrated circuit at a very low temperature. The integrated circuit can be cooled by cooling means employed for Josephson elements.

## Brief Description of the Drawings

Fig. 1 is a section view of a conventional CMOS type device;

Figs. 2A, 2B, 2C, 3A, 3B and 3C are diagrams of embodiments according to the present invention;

Fig. 4 is a graph of the temperature dependency of the gain ß of a parasitic bipolar transistor, measured by experiments;

Fig. 5 is a graph of the temperature dependency of the sheet resistance in the well region, measured by experiments;

Fig. 6 is a graph of the temperature dependency of the latch-up phenomenon, measured by experiments;

Fig. 7 is a section view of a parasitic MOS transistor according to the embodiment of the present invention;

Fig. 8 is a graph of the temperature dependency of the threshold voltages of active MOS transistors and parasitic MOS transistors, measured by experiments;

Fig. 9 is a graph of the temperature dependency of the speed and power consumption of a multi-stage inverter, measured by experiments; and

Figs. 10A, 10B, 11A, 11B, 12, 13, 14A, 14B, 15, 16A, 16B and 16C are diagrams of further embodiments according to the present invention.

## Description of the Preferred Embodiments

Figs. 2A and 2B illustrate a first embodiment according to the present invention. A CMOS type inverter circuit consisting of a p-channel MOS transistor Q1 and an n-channel MOS transistor Q2 as shown in Fig. 2A, is formed based upon a so-called CMOS structure shown in Fig. 2B. That is, the p-channel MOS transistor is composed of $p^+$-type regions 205, 206 and a gate electrode 208 on the surface region of an n-type silicon substrate 201. The n-channel MOS transistor is composed of $n^+$-type regions 203, 204 in a p-type well region, and a gate electrode 207. Gate insulating films 200 are composed of $SiO_2$ or the like. This element is operated at a temperature lower than 100°K, for example at 77°K, because of reasons that will be mentioned later. The CMOS structure can also be realized by forming an n-type well region 210 in a p-type silicon substrate 209 as shown in Fig. 2C.

Figs. 3A and 3B show an embodiment consisting of a CMOS type circuit of the transistors Q1, Q2, and a circuit formed by coupling a junction field-effect transistor Q3 and an MOS transistor Q4. As shown in a section view of Fig. 3B, a p-type well region 202' has an opening at which the surface of the n-type silicon substrate is exposed, and an $n^+$-type region 211 is formed on the surface of the opening. Then, a junction transistor is formed with the $n^+$-type region 212 formed on the surface of the n-type silicon substrate 201 serving as the drain, the $n^+$-type region 211 serving as the source, and the p-type well region 202' serving as a junction-type gate. The junction transistor and the n-channel MOS transistor in the p-type well region 202' are coupled together to obtain the circuit composed of transistors Q3 and Q4 of Fig. 3A. Other reference numerals denote the same portions as those of Fig. 2B. The circuit of this embodiment is also operated at a temperature lower than 100°K.

As shown in Fig. 3C, furthermore, the conductivity types of each of the portions may be reversed.

The effects of the above embodiments will be described below in conjunction with Figs. 4, 5 and 6.

The latch-up phenomenon that takes place in CMOS devices is caused by the thyristor action of a parasitic bipolar transistor that forms in the well region and in the substrate. So far, the n-channel MOS transistor and the p-channel MOS transistor had been formed relatively far apart to decrease the gain $\beta$ of the parasitic bipolar transistor, thus sacrificing a degree of integration. Fig. 4 shows experimental data on the temperature dependency of the gain $\beta$ of the parasitic bipolar transistor. As the temperature decreases from 300°K to 77°K, the gain $\beta$ decreases to 1/60. As the temperature further decreases to 4.2°K, the gain $\beta$ decreases to 1/520. It will therefore be apparent that the parasitic bipolar transistor ceases to contribute to developing latch-up phenomenon at very low temperatures.

Fig. 5 shows experimental data on the sheet resistance of the well region produced by the parasitic bipolar transistor. As the temperature decreases from 300°K to 77°K, the resistance decreases to 1/3.8. Due to the decreased resistance, the bias voltage applied to the parasitic bipolar transistor is reduced and the gain ß decreases. Therefore, the latch-up phenomenon takes place less. As the temperature further decreases to 4.2°K, the resistance becomes greater than 10 megaohms/□ due to the freeze-out of impurities, and the latch-up current does not flow any more. Further, the gain ß of the parasitic bipolar transistor decreases and the latch-up phenomenon does not develop. It was also found that a similar temperature dependency exists for the sheet resistance of the substrate.

Fig. 6 shows the results of the measurements on the temperature dependency of the latch-up phenomenon. The ordinate represents a DC injection current that is required to develop the latch-up phenomenon. As the injection current increases, an increasing current must be supplied to the parasitic bipolar transistor to latch-up it. Namely, the latch-up phenomenon develops less easily. The latch-up phenomenon did not take place at 77°K even when the injection current that was supplied at 300°K was increased by ten thousand times. It is obvious that the problem of latch-up diminishes at very low temperatures, and virtually disappears at temperatures lower than 100°K.

Accordingly, the n-channel MOS transistor and the p-channel MOS transistor can be formed close to each other, increasing the degree of integration.

Isolation of the MOS transistors also plays an important role in the forming of highly integrated CMOS devices.

Fig. 7 is a section view of a CMOS device according to an embodiment of the present invention which includes parasitic MOS transistors. In Fig. 7, symbols Q4 and Q6 denote active p-channel MOS transistors, Q5 denotes a parasitic p-channel MOS transistor, Q7 and Q9 denote active n-channel MOS transistors, and Q8 denotes a parasitic n-channel MOS transistor. The active MOS transistors use gates 1 and gate oxide films 2, the p-channel MOS transistors use $p^+$-type diffusion layers 3, 4, 12 and 13 as sources and drains, and the n-channel MOS transistors use $n^+$-type diffusion layers 6, 7, 14, 15 as sources and drains. Here, the p-channel MOS transistors Q4 and Q6 are formed in the n-type well region which has a higher impurity concentration than the $n^-$-type substrate.

The p-channel MOS transistors Q4 and Q6, however, may also be formed in the $n^-$-type substrate. Gates of the parasitic MOS transistors are formed by metal interconnection lines 16, and gate oxide films are formed by field oxide films 17. In order to increase the degree of integration, electric isolation must be obtained without increasing the channel lengths $\ell_1$, $\ell_2$ of the parasitic MOS transistors.

Fig. 8 shows the results of the measurements on the threshold voltages of the active MOS transistors and of the parasitic MOS transistors. Threshold voltages of the parasitic n-channel MOS transistor and parasitic p-channel MOS transistor increase with lower temperatures as compared with the values at 300°K, and become greater than the difference between the threshold voltages of the active MOS transistors. That is, there is no problem with electric isolation even when the device is operated at low temperatures.

Fig. 9 shows the results of the measurements on the temperature dependency of the operational speed and power dissipation of a CMOS inverter. Owing chiefly to the mobility of electrons and the increase in positive holes at low temperatures, the operation speed is 1.6 times higher when the device is operated at 77°K than at 300°K, and 3 times higher at 4.2°K than at 300°K. The threshold voltage increases with the decrease in temperature. Therefore, the power dissipation increases little with increased operation speed.

When operated at low temperatures, the CMOS devices feature very high speed with low electric power consumption. Even when the threshold voltage is set to a small value, it increases when the device is operated at low temperatures, and high-speed operation can be realized.

Fig. 10A shows a further embodiment of the present invention according to which the CMOS device is formed directly in the n-type substrate 10 instead of being formed in the well region. Both the p-channel MOS transistor Q1 and the n-channel MOS transistor Q2 are formed in the n-type silicon substrate 10. Since the substrate 10 has a low impurity concentration (smaller than $10^{17}$ $cm^{-3}$), the impurities freeze out at temperatures lower than 20°K and the substrate exhibits a high resistance (greater than 1 gigaohms/□). Therefore, electric isolation is obtained for the CMOS device of Fig. 10A. The electric isolation $\ell_3$ can also

be obtained between the p-channel MOS transistor and the n-channel MOS transistor of Fig. 10A, since the substrate 10 exhibits increased resistance. Therefore, this structure is effective for increasing the degree of integration. The increased resistance helps decrease the gate capacitance, junction capacitance and capacitance of interconnection lines, that are parasitic in the substrate 10, and, therefore helps increase the operation speed. The increased resistance further helps eliminate the formation of parasitic bipolar transistors and the latch-up phenomenon. In the pn junction, the leakage current decreases to reduce electric power consumption. When operated at low temperatures, carrier mobility increases, accomplishing high-speed operation.

As shown in Fig. 10B, furthermore, the conductivity types of each of the portions of Fig. 10A may be reversed, and the p-channel MOS transistor and the n-channel MOS transistor may be formed in the p-type silicon substrate. In this case also, the device is operated at a temperature lower than 20°K.

Fig. 11A shows still another embodiment of the present invention. According to this embodiment, a common p-type well region 8 having a low impurity concentration (smaller than $10^{17}$ $cm^{-3}$) is formed for the n-channel MOS transistor and the p-channel MOS transistor in the substrate 10 of Fig. 10A. When the device of this embodiment is operated at a temperature lower than 20°K, the impurities freeze out and the p-type well region 8 and the substrate 10 exhibit high resistances. Provision of the p-type well region 8 helps isolate more reliably the MOS transistors from the substrate 10 than in the case of Fig. 10A, and further reduces parasitic capacitance relative to the substrate 10, enabling the operation speed to be correspondingly increased. As explained in reference to Fig. 10A, furthermore, the operation speed is increased owing to increased carrier mobility, the degree of integration is raised owing to simplified isolation construction, and the consumption of electric power is reduced owing to reduction in the leakage current in the pn junction. In this embodiment, of course, the conductivity types of each of the portions may be reversed.

Namely, the conductivity types of each of the portions of Fig. 11A may be reversed as shown in Fig. 11B.

Fig. 12 shows a yet further embodiment employing a high resistance 19 (greater than 1 megaohms) which can be highly integrated at temperatures lower than 20°K. A p-type well region 8 with a hole is formed in the upper portion of the substrate 10 having a low impurity concentration (smaller than $10^{17}$ $cm^{-3}$). One side thereof is connected to a terminal of $n^+$-type layer 4 and the other side to a terminal of $n^+$-type layer 18 formed under the hole and under the p-type well region 8, thereby constituting a high resistance 19. At temperatures lower than 20°K, the impurities in the substrate 10 are frozen out, and a high resistance is produced between the terminal 4 and the terminal 18. This construction resembles a junction field-effect transistor. In this temperature range, however, a junction field-effect transistor would not operate. Here, a high resistance is realized by using a polycrystalline silicon that is generally used for producing a high resistance at ordinary temperatures. The high resistance therefore assumes lateral construction. The high resistance 19 is formed in the vertical construction and is effective for increasing the degree of integration.

Fig. 15 shows an example in which one terminal 4 of the high resistance 19 is connected to the drain 4 of the n-channel MOS transistor Q2. In this case, the transistor Q2 and the high resistance 19 can be formed close to each other. Fig. 13 is a circuit equivalent to Fig. 12.

The high resistance shown in Fig. 12 can be employed in the CMOS structure described earlier.

Fig. 14A shows an example, and Fig. 14B shows the case when the conductivity types of each of the portions of Fig. 14A are reversed.

A further embodiment of the present invention is shown in Fig. 15. Namely, a flip-flop circuit is formed by combining two sets of high resistors 19 from Fig. 12 and n-channel MOS transistors Q2. The high resistances 19, 19' assume vertical construction, and a terminal 18 serves as a common terminal in the substrate, contributing to increasing the degree of integration. At temperatures lower than 20°K, the device works as a static memory cell which consumes little electric power.

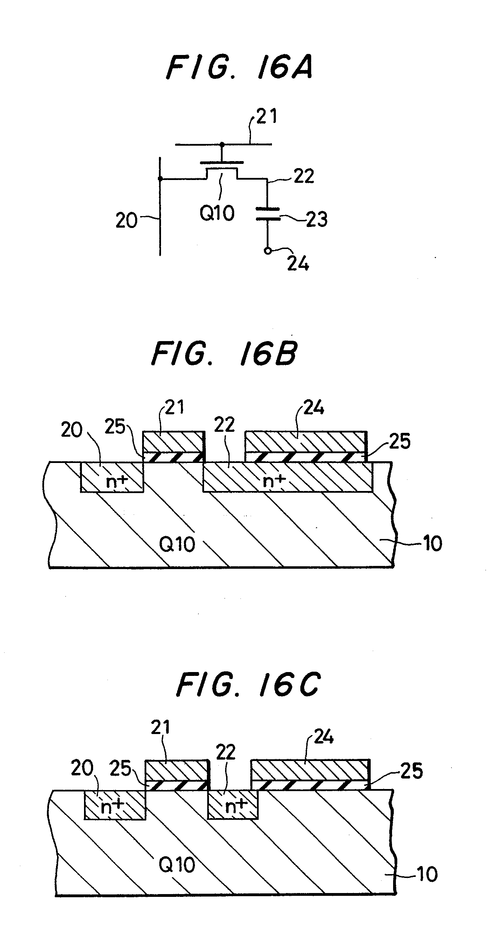

Fig. 16A shows an embodiment in which the present invention is adapted to a dynamic memory cell, the cell being composed of a storage capacitance 23 and a transfer MOS transistor Q10. An electric charge stored in a storage node 22 is sent to a data line by a transfer MOS transistor that is addressed by a word line 21 and a data line 20, and is detected and amplified by a sense amplifier. The storage capacitance may be established by a gate 24, an $n^+$-type diffusion layer 22 and a thin oxide film as shown in Fig. 16B, or may be established between the channel and the gate of the n-channel MOS transistor, which consists of a source 22 of an $n^+$-type diffusion layer and a gate 24 as shown in Fig. 16C. To date, memory cells has had to be refreshed frequently due to leakage current which flows from the pn junction into the storage capacitance or due to recombination of electrons and positive holes in the surface inversion layer. When operated at a temperature lower than 100°K, however, the leakage current decreases between the source 20 and the drain 22 of a transfer MOS transistor, the leakage current decreases in the pn junction, and the recombination rate of electrons and positive holes decreases in the surface inversion layer. Accordingly, the leakage of electric charge from the storage node decreases, the frequency with which memory needs to be refreshed decreases, and the consumption of electric power is reduced.

<u>What is claimed is</u>

1. A semiconductor device which comprises: a first field-effect transistor (200, 205, 206, 208) which is formed in a region (201; 210, 210') of a first type of conductivity in a silicon substrate, and which includes source and drain regions (205, 206) of a second type of conductivity, and an insulation gate (200, 208); and a second field-effect transistor (200, 203, 204, 207) which is formed in a region (202; 209; 202) of a second type of conductivity in the silicon substrate, and which includes source and drain regions (203, 204) of the first type of conductivity, and an insulation gate (200); wherein said semiconductor device is operated in a temperature range which is lower than 100° K. (Figs. 2B; 2C; 3B; 3C).

2. A semiconductor device which comprises: a first field-effect transistor (1, 2, 6, 7; 1, 2, 3, 4) which is formed in a region (10, 10') of a first type of conductivity (n ; P) in a silicon substrate, and which includes source and drain regions (6, 7; 3, 4) of the first type of conductivity (n; P) and an insulation gate (2); and a second field-effect transistor (1, 2, 3, 4; 1, 2, 6, 7) which is formed in the region of the first type (10', 10) of conductivity (n; P), and which includes source and drain regions (3, 4; 6, 7) of a second type of conductivity (P; n), and an insulation gate (2); wherein said semiconductor device is operated in a temperature range which is lower than 20° K. (Figs. 10A; 10B).

3. A semiconductor device according to claim 2, wherein the bottom portion (10, 10') of said silicon substrate has the second type of conductivity (n; P). (Figs. 11A; 11B).

4. A semiconductor device in which a region (10, 10') of a first type of conductivity (n; P) is exposed in an opening which is formed in a portion (8; 5) of a well region of a second type of conductivity (P; n) that is formed on the surface of a silicon substrate of the first type of conductivity (n; P); a first highly doped region (9, 9') of the first type of conductivity (n; P) is formed on the surface of said opening, a second highly doped region (18; 18') of the first type of conductivity (n; P) is formed in a portion of said silicon substrate, and the semiconductor device is operated in a temperature range in which impurities which are present between said first highly doped region and said second highly doped region are frozen out. (Figs. 14A; 14B).

FIG. 1

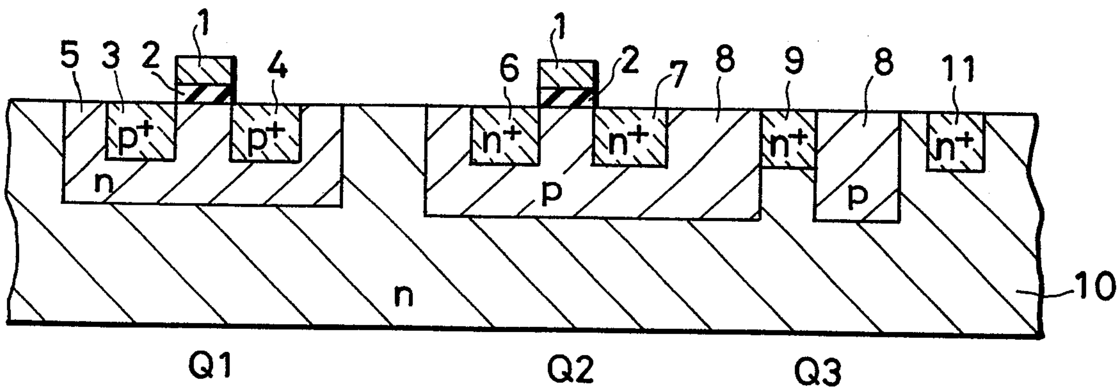


FIG. 2A

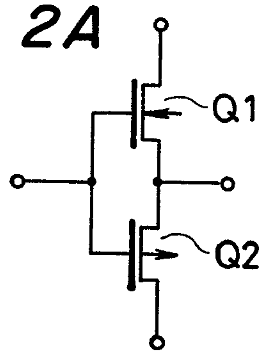


FIG. 2B

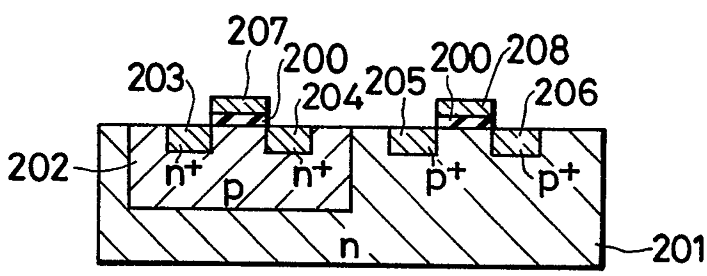


FIG. 2C

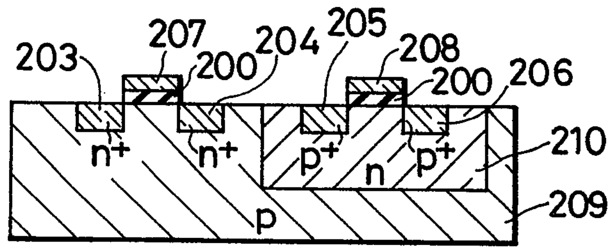

FIG. 3A

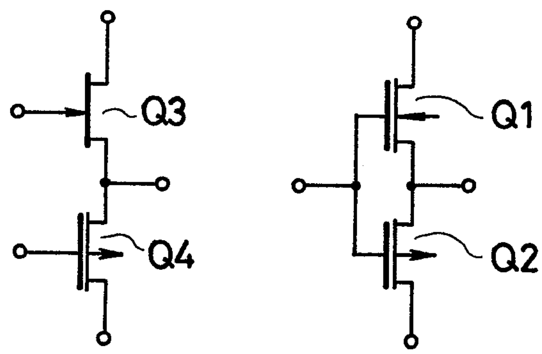


FIG. 3B

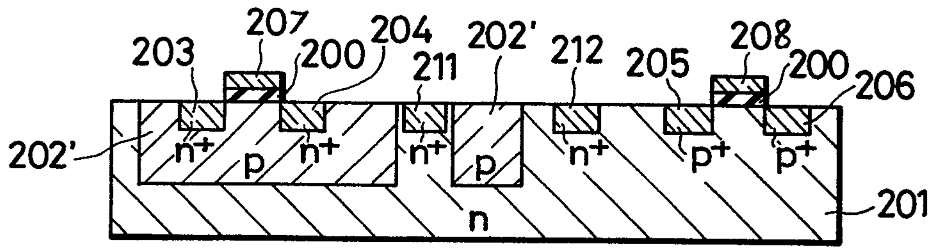


FIG. 3C

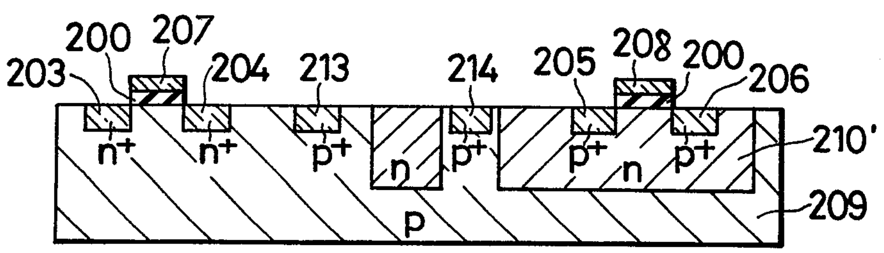

FIG. 4

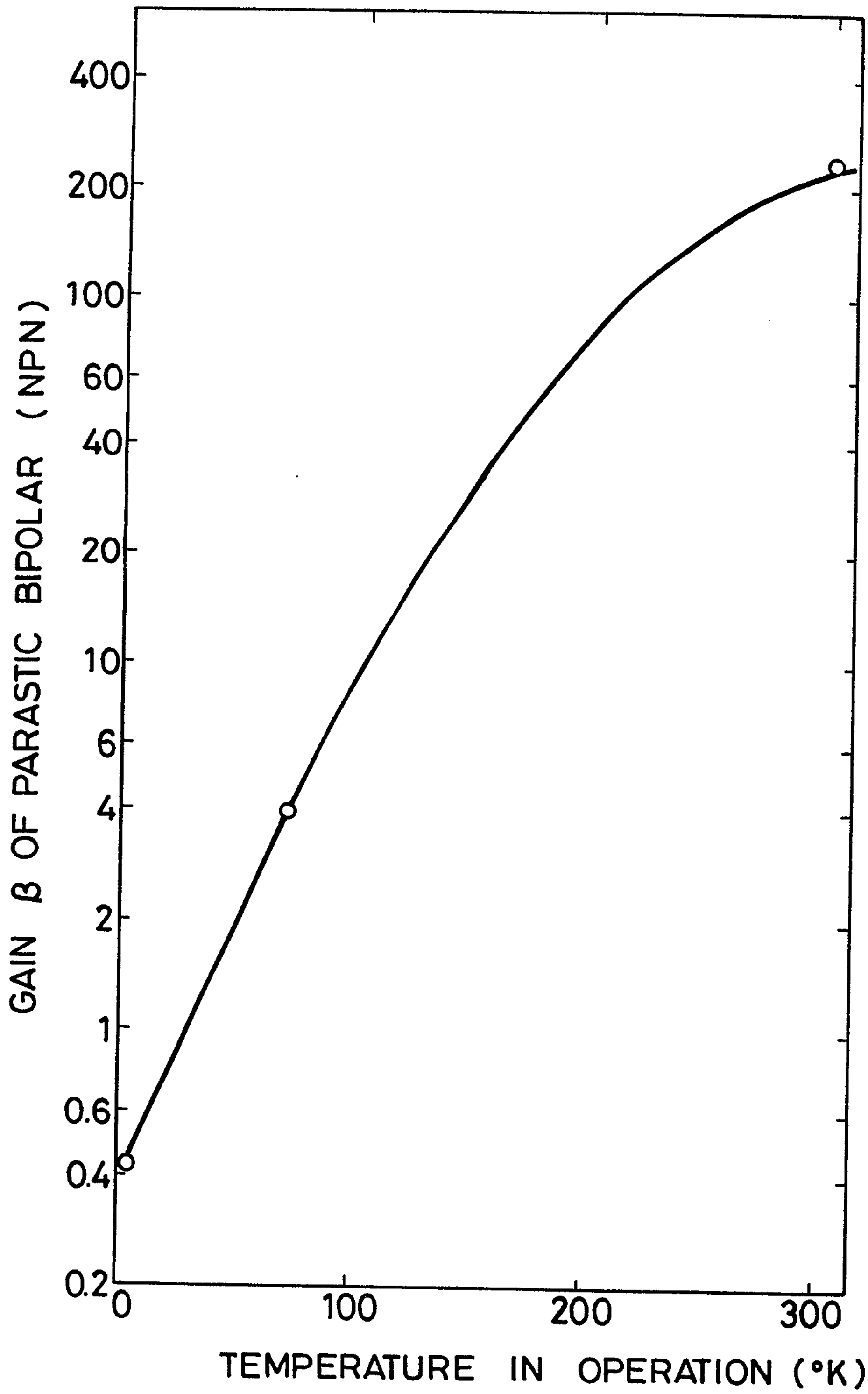
GAIN β OF PARASTIC BIPOLAR (NPN)
400
200
100
60
40
20
10
6
4
2
1
0.6
0.4
0.2
0
100
200
300
TEMPERATURE IN OPERATION (°K)

0114061

4/11

FIG. 5

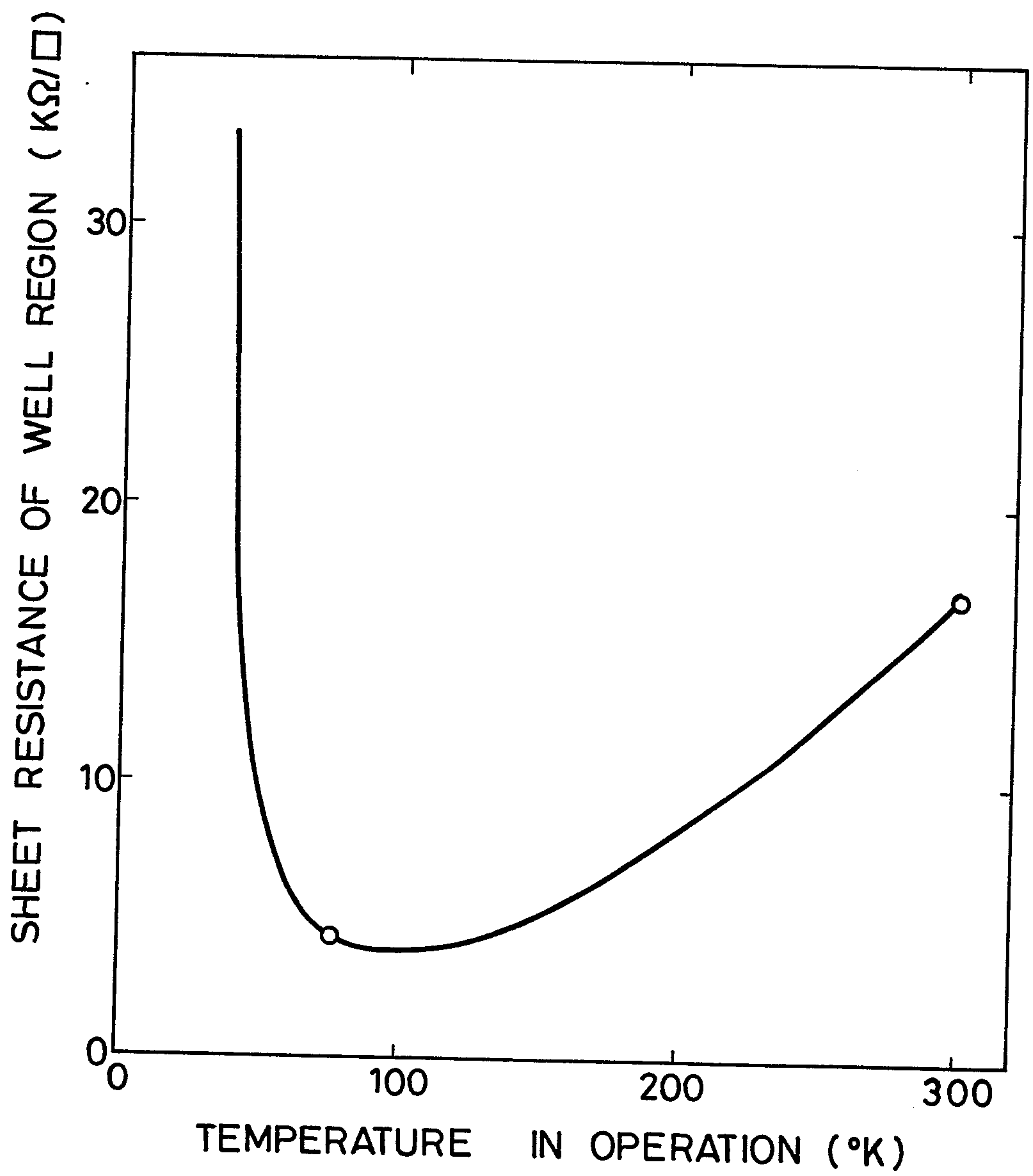

FIG. 6

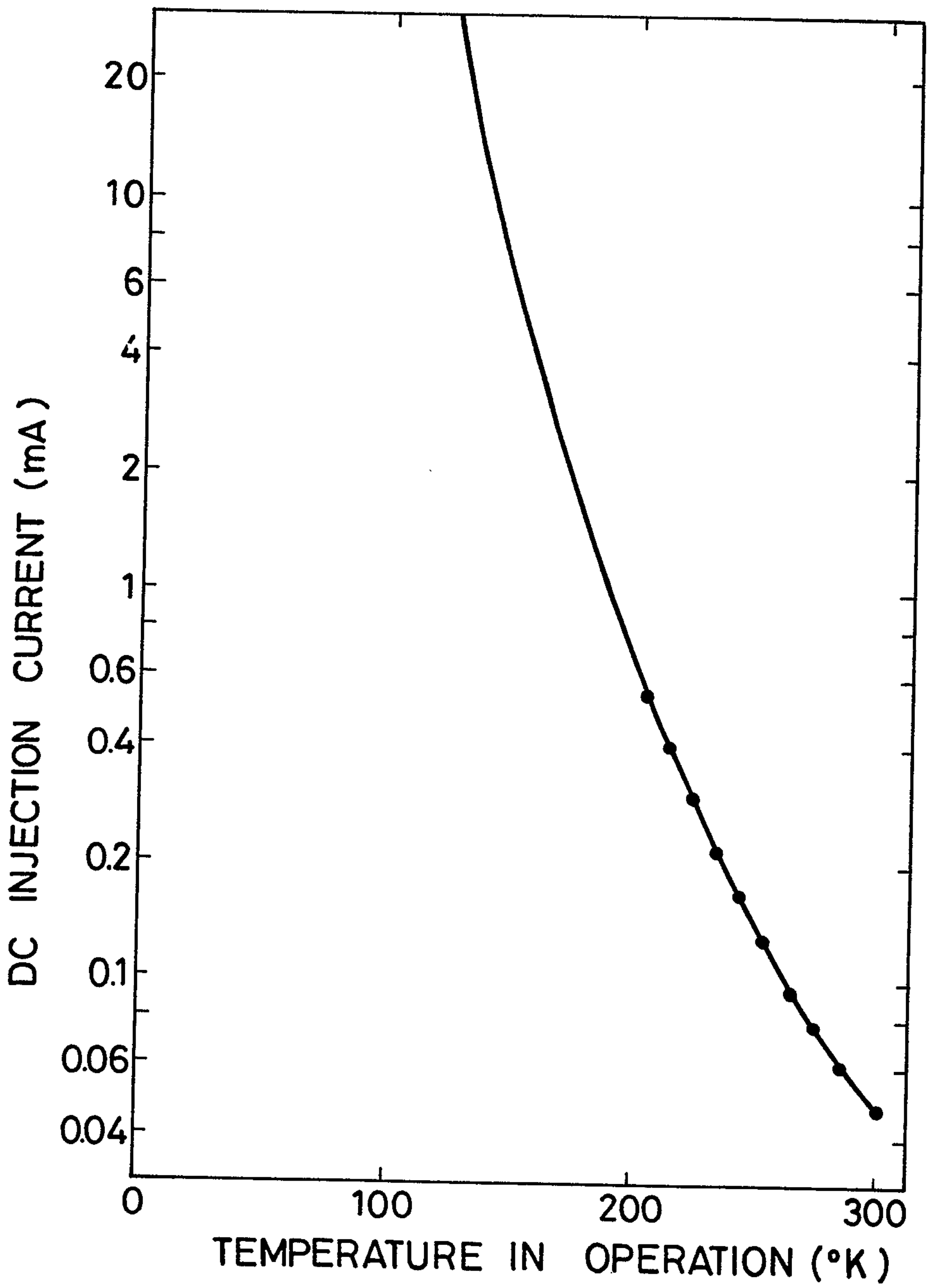
DC INJECTION CURRENT (mA)
20
10
6
4
2
1
0.6
0.4
0.2
0.1
0.06
0.04
0
100
200
300
TEMPERATURE IN OPERATION (°K)

FIG. 7

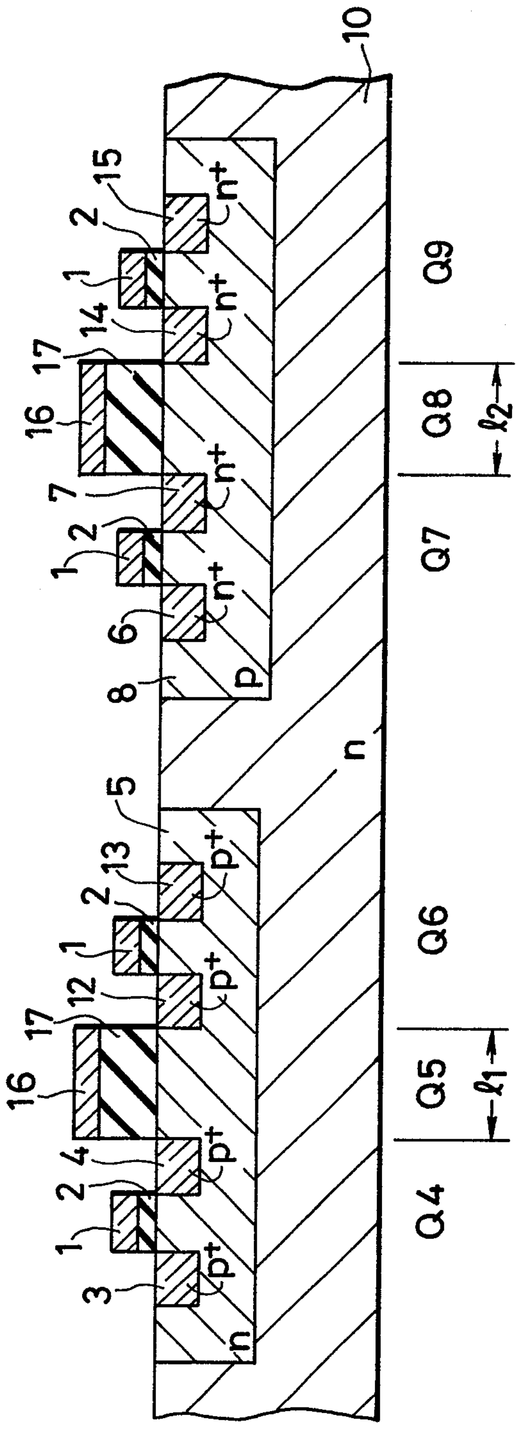

FIG. 8

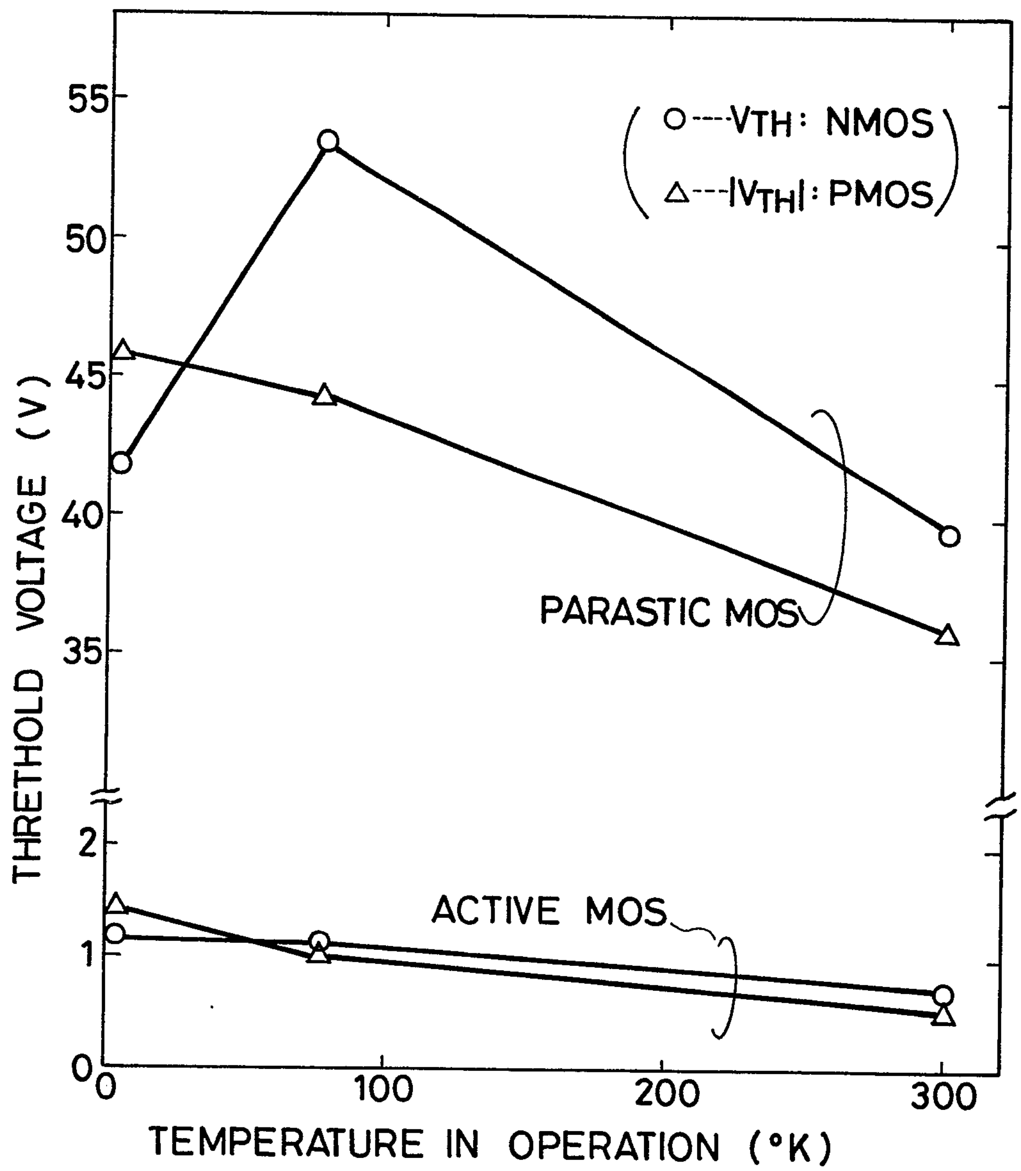
○---$V_{TH}$ : NMOS
△---$|V_{TH}|$ : PMOS
PARASTIC MOS
ACTIVE MOS
THRETHOLD VOLTAGE (V)
55
50
45
40
35
2
1
0
0
100
200
300
TEMPERATURE IN OPERATION (°K)

FIG. 9

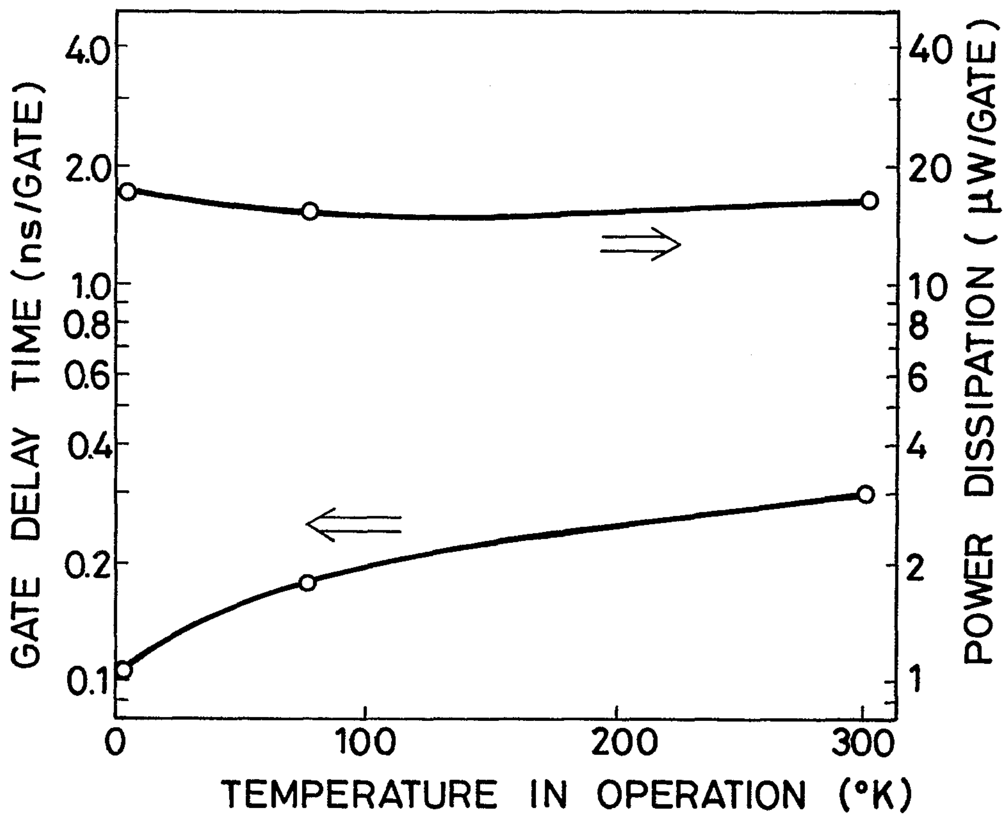


FIG. 10A

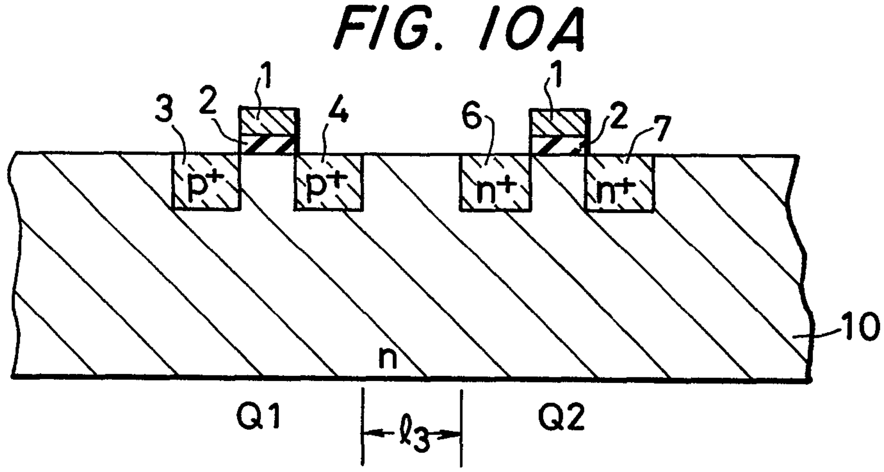


FIG. 10B

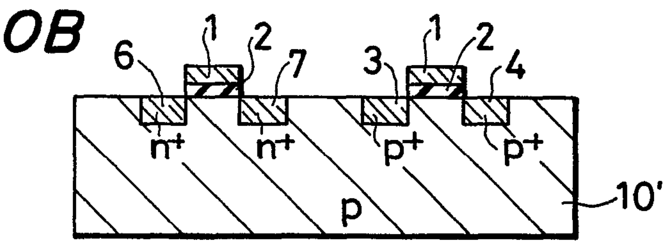

FIG. 11A

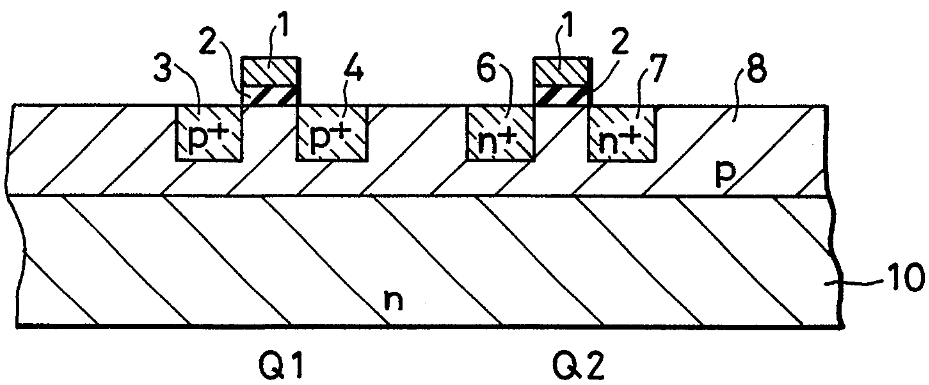


FIG. 11B

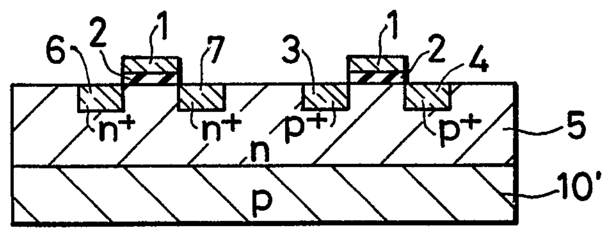


FIG. 12

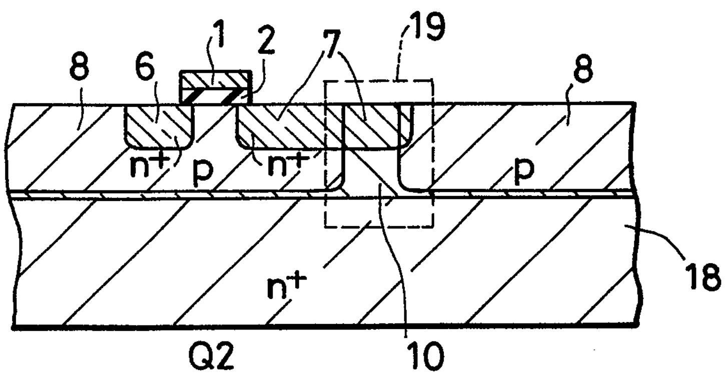


FIG. 13

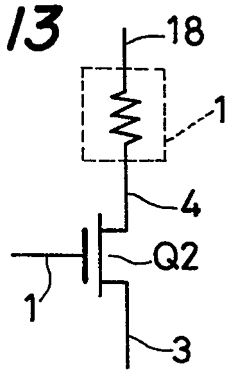

FIG. 14A

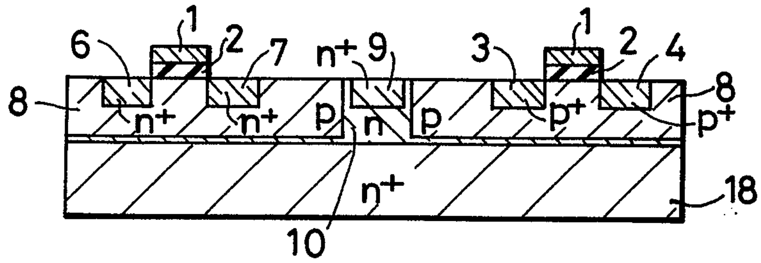


FIG. 14B

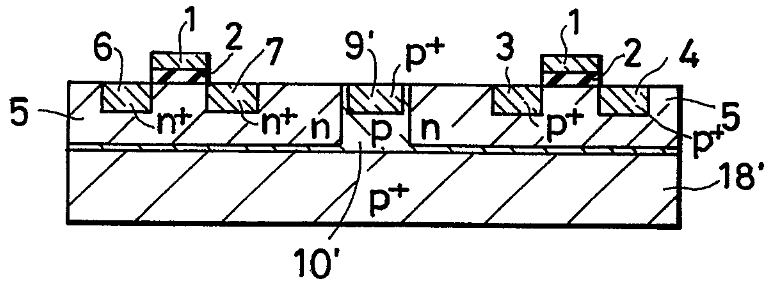


FIG. 15

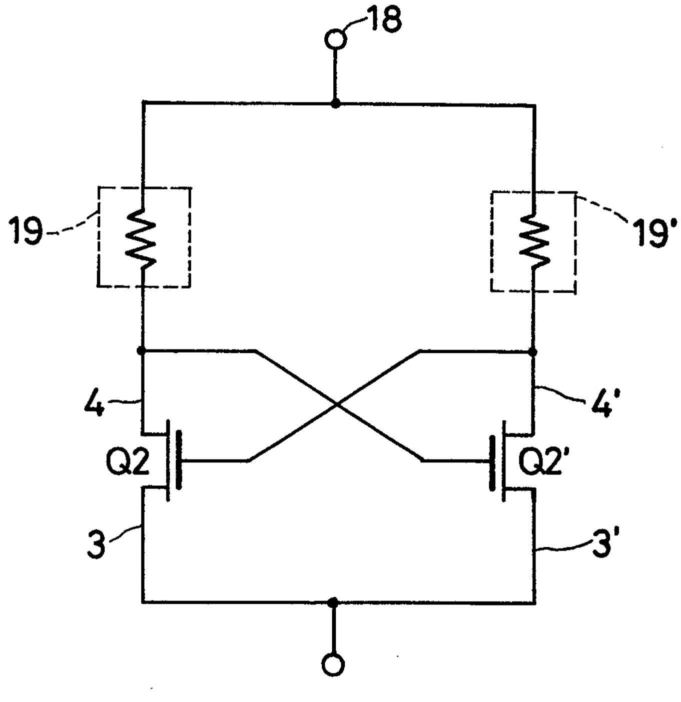

FIG. 16A

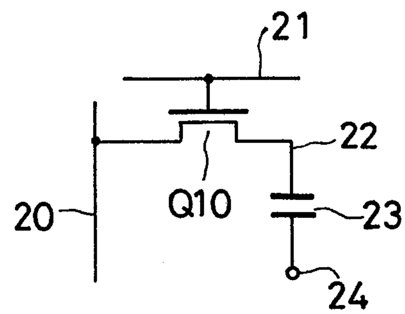


FIG. 16B

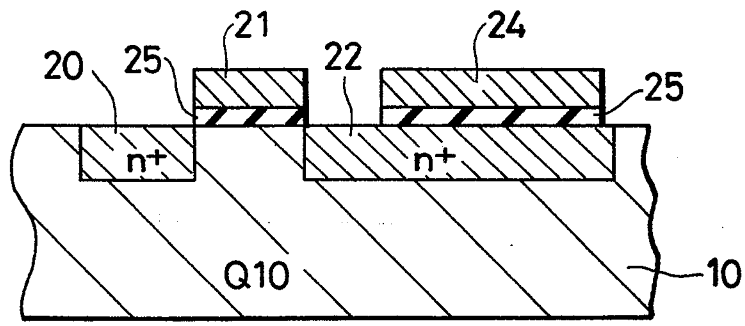


FIG. 16C